# EUROPEAN PATENT APPLICATION

(11) **EP 2 369 039 A1**
(43) Date of publication of application: **28.09.2011**
(21) Application number: 11158430.6
(22) Date of filing: 16.03.2011
(51) Int. Cl.: C23C 16/54

(54) **Film formation apparatus**

(30) Priority: 18.03.2010 JP 2010062919
(71) Applicant: Fujifilm Corporation, Minato-ku Tokyo 106-0031 (JP)
(72) Inventor: Hasegawa, Masataka, Ashigara-kami-gun Kanagawa (JP)
(74) Representative: HOFFMANN EITLE

(57) **Abstract**

A film formation apparatus comprises: a first unit having a vacuum chamber in which film formation is performed on the base film; a second unit having a feeding system for feeding the base film; and a joining unit that conductively joins the first unit and second unit, wherein the first unit and the second unit are constructed by combining together, and no potential difference occurs between the first unit and second unit during film formation.

## Description

### BACKGROUND OF THE INVENTION

The present invention relates to a film formation apparatus that forms a film while feeding a lengthy base film. In particular, it relates to a film formation apparatus that can stably manufacture proper products by preventing generation of plasma in unnecessary regions.

Various functional films (functional sheets) including gas barrier films, protective films, and optical films such as optical filters and antireflective films are used in various devices including optical devices, display devices such as liquid crystal display devices and organic EL display devices, semiconductor devices, and thin-film solar batteries.

These functional films have been produced by film formation (thin film formation) through vacuum film formation method (vapor deposition method) accompanied by generation of plasma, such as sputtering and plasma-enhanced CVD.

Continuous film formation of a film while feeding a lengthy base film (web-like substrate) in the longitudinal direction is preferred for efficient film formation with high productivity by vapor-phase film formation method.

A known apparatus for performing such film formation is a so-called roll-to-roll film formation apparatus, which feeds a base film from a base film roll obtained by winding a lengthy base film into a roll, and winds the base film on which film formation has been completed into a roll.

This roll-to-roll film formation apparatus passes the lengthy base film from the base film roll to a winding shaft along a predetermined path which passes through the film formation position where a film is formed on the base film, and continuously forms a film on the base film which is fed in the longitudinal direction to the film formation position while the base film is fed from the base film roll in synchronization with the base film on which film formation has been completed being wound by a winding shaft.

Further, among such film formation apparatuses that use the roll-to-roll system, one known apparatus is one that performs film formation while feeding the base film by winding it on the circumferential surface of a cylindrical drum.

For example, JP 2006-152416 A discloses a plasma-enhanced CVD device in which an electrode pair is formed by this conductive drum and a counter-electrode in which a plurality of nozzles that emit raw material gas are formed (hereinafter referred to as "shower head electrode"), which is arranged facing the drum, wherein the surface of the counter-electrode that faces the drum has a curved surface parallel to the drum.

There are also cases where such a film formation apparatus that uses the roll-to-roll system is configured by combining a plurality of units, rather than being formed by only one unit.

For example, as described in JP 2006-152416 A, if it is a plasma-enhanced CVD device that uses a drum that winds and feeds the base film, in which the electrode pair is constructed of the drum and a shower head electrode, the apparatus is composed of, for example, an opposing truck unit arranged in a fixed manner which has a vacuum chamber and a shower head electrode, and a truck unit that can move, in which a base film feeding system that includes the drum is configured.

In this case, the plasma-enhanced CVD device is constructed by combining the opposing truck unit and the truck unit such that the feeding system is inserted in the vacuum chamber by moving the truck unit. Further, by combining the two units, it is possible to close the vacuum chamber and reduce the pressure in accordance with film formation.

In this apparatus, film formation is performed by supplying plasma excitation power to the shower head electrode or drum, and grounding the other. Or, film formation is performed by supplying plasma excitation power to the shower head electrode and supplying bias power to the drum (or the reverse).

Further, the two units are electrically connected by mutually joined surfaces, and both units are grounded.

Here, since a plasma-enhanced CVD device that uses the roll-to-roll system generally requires equipment such an electrode/power supply system and a base film feeding system that includes a drum, the footprint of the equipment ends up being large. For this reason, a distribution in ground potential tends to occur.

Further, insulating seal members such as O rings are arranged at the joined parts between the opposing truck unit and the truck unit to hold the inside of the vacuum chamber at a predetermined pressure, and there are cases where they ends up hindering the electrical connection of the joined parts between the two units. Additionally, through use of the apparatus, warping of the apparatus or deformation of the seal members occurs due to opening and closing of the opposing truck unit and truck unit, and deposition of film-forming gases occurs on the joined parts, and these, too, end up hindering the electrical connection of the joined parts of the two units.

For this reason, in a plasma-enhanced CVD device by the roll-to-roll system composed of an opposing truck unit and a truck unit, a difference in electrical potential ends up occurring between the opposing truck unit and truck unit, and due to this potential difference, plasma ends up being generated in unnecessary regions outside the film formation region (between the drum and the shower head electrode), such as in the chambers where base film feeding and winding are performed.

When plasma is generated in unnecessary regions in this way, the base film ends up being damaged by plasma before film formation, and degradation of film quality, such as breakage or flaking off of the film, end up occurring due to this base film damage, and it becomes impossible to perform proper film formation.

Further, power loss due to generation of heat occurs due to unnecessary electrical discharge outside the film formation region, and the plasma in the film formation region ends up becoming unstable.

Additionally, a film ends up depositing on the walls inside the vacuum chamber other than in the film formation region, and as a result, the wall potential varies, and the state of the plasma used for film formation ends up varying over time, resulting in unstable film formation. In addition, there is also the problem that the locations where cleaning is required for removing deposited film inside the apparatus end up increasing, and this adversely affects the maintainability of the apparatus.

An object of the present invention is to solve the above problems of prior art, and to provide a film formation apparatus constructed by combining units such as a truck unit and an opposing truck unit, which performs film formation by plasma-enhanced CVD, sputtering, etc., while feeding a lengthy base film using a roll-to-roll system, wherein the occurrence of a potential difference between the units can be prevented, and therefore, generation of unnecessary plasma caused by a potential difference between units is inhibited, and damage to the base film by unnecessary plasma, power loss, destabilization of plasma, deposition of film in unnecessary locations, etc., can be greatly reduced.

### SUMMARY OF THE INVENTION

To achieve the above objective, the present invention provides a film formation apparatus which performs film formation while feeding a lengthy base film in the longitudinal direction thereof, the film formation apparatus comprising: a first unit having a vacuum chamber in which film formation is performed on the base film; a second unit having a feeding system for feeding the base film; and joining means that conductively joins the first unit and second unit, wherein the first unit and the second unit are constructed by combining together, and no potential difference occurs between the first unit and second unit during film formation.

### BRIEF DESCRIPTION OF THE DRAWINGS

FIGS. 1A and 1B are a schematic elevation view and a schematic side view showing an embodiment of the film formation apparatus of the present invention, respectively.
FIG. 2 is a schematic view as seen when the film formation apparatus shown in FIG. 1 is disassembled.
FIG. 3 is a schematic view for explaining the configuration of the film formation apparatus shown in FIG. 1.

### DETAILED DESCRIPTION OF THE INVENTION

Next, the film formation apparatus of the present invention is described in detail by referring to the preferred embodiments shown in the accompanying drawings.

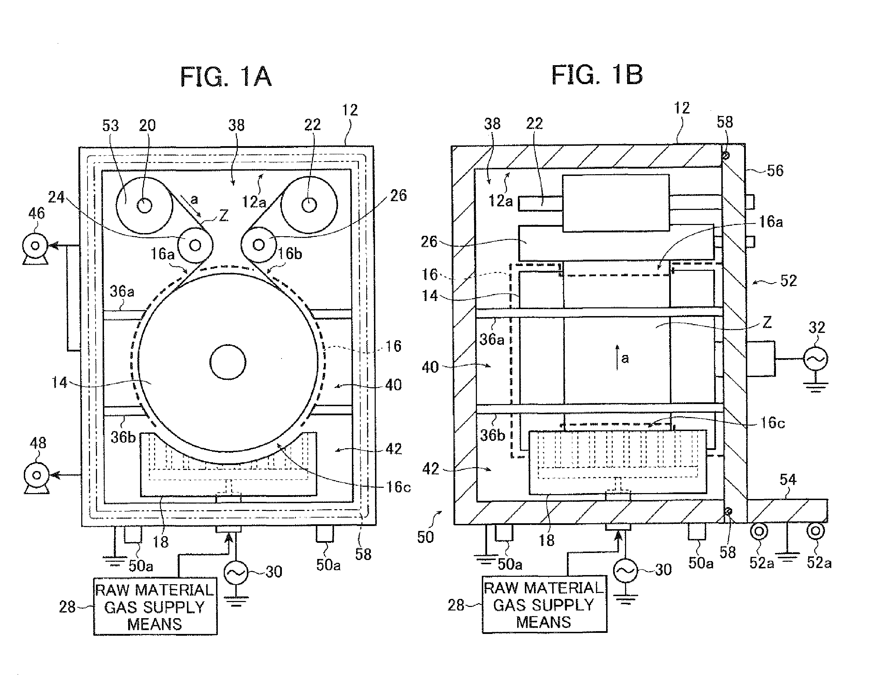

FIG. 1 is a schematic view showing an embodiment of the film formation apparatus of the present invention.

The film formation apparatus 10 shown in FIG. 1 performs film formation by plasma-enhanced CVD while feeding a lengthy base film Z in the longitudinal direction. In FIG. 1, FIG. 1A is a view (elevation view) seen from the direction perpendicular to the feeding direction (direction of arrow a as shown in the drawing) of the base film Z, and FIG. 1B is a view (side view) seen from the downstream side of the feeding direction of the base film Z.

This film formation apparatus 10 comprises a vacuum chamber 12, and a drum 14, shell 16, shower head electrode 18, supply shaft 20, winding shaft 22, guide rollers 24 and 26 and partition walls 36a and 36b arranged inside the vacuum chamber 12.

Further, raw material gas supply means 28 and an RF power supply 30 are connected to the shower head electrode 18, and a bias power supply 32 is connected to the drum 14.

In the illustrated film formation apparatus 10, the shell 16 has a substantially cylindrical shape, arranged so as to encompass the drum 14, but in FIG. 1, to show the configuration of the apparatus more clearly, the shell 16 is illustrated by a dotted line, making its inside visible. Further, FIG. 1A is an elevation view showing the inside of the vacuum chamber 12 (in the state where the wall 56 described below has been removed).

Further, in addition to the members illustrated in the diagram, the film formation apparatus 10 may also have various members arranged in an apparatus that performs film formation while feeding the base film Z, such as various sensors and guides.

The inside of the vacuum chamber 12 is separated in a substantially airtight manner from, as seen from the top of the diagram, an unwinding chamber 38, a feeding chamber 40 and a film formation chamber 42 by two partition walls 36a and 36b.

Additionally, vacuum evacuation means 46 is connected to the unwinding chamber 38 and feeding chamber 40, and vacuum evacuation means 48 is connected to the film formation chamber 42.

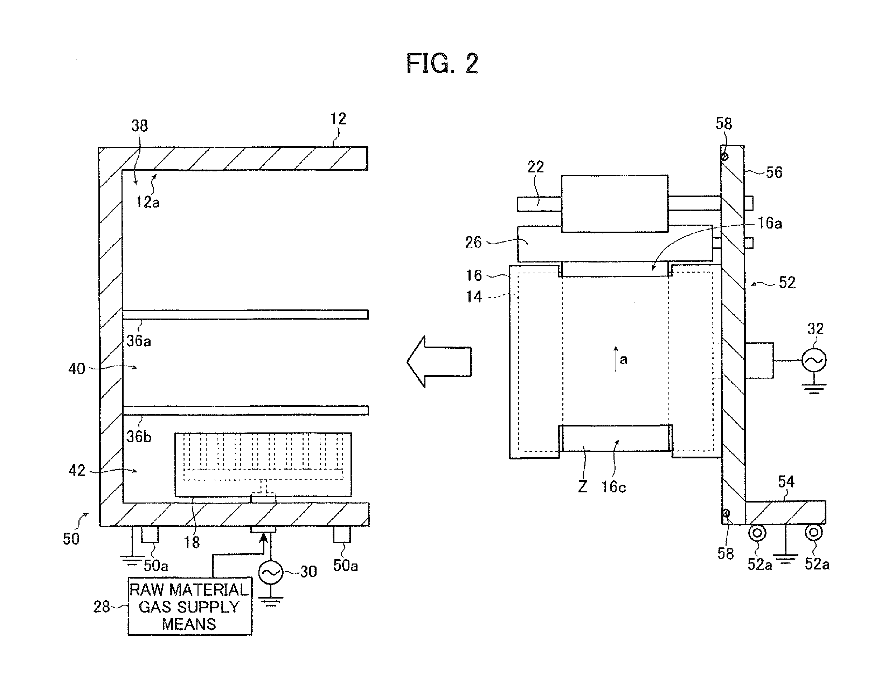

Further, the film formation apparatus 10 is constructed from an opposing truck unit 50 and a truck unit 52, as shown schematically in FIG. 2. Note that FIG. 2 is the same side view as FIG. 1B.

As shown in FIG. 2, the opposing truck unit 50 has a vacuum chamber 12, a shower head electrode 18 and partition walls 36a and 36b. On the other hand, the truck unit 52 has a feeding system for the base film Z, namely a drum 14, a supply shaft 20, a winding shaft 22 and guide rollers 24 and 26. Further, the shell 16 is also provided in the truck unit 52.

Therefore, in the illustrated film formation apparatus 10, the opposing truck unit 50 is the first unit in the present invention, and the truck unit 52 is the second unit in the present invention.

In the film formation apparatus 10, the opposing truck unit 50 which has a vacuum chamber 12 is arranged in a fixed manner by legs 50a. On the other hand, the truck unit 52 which has the feeding system for the base film Z is constructed such that it can move by means of casters 52a.

The film formation apparatus of the present invention is not limited thereto, and may be configured such that the first unit can move and the second unit is arranged in a fixed manner, or such that both units can move.

In the film formation apparatus 10, the lengthy base film Z is supplied as a base film roll 53 which has been wound into a roll.

When the base film Z is supplied from the base film roll 53 of the unwinding chamber 38 and fed in the longitudinal direction (direction of arrow a in the drawing) while being wound onto the drum 14, a film is formed in the film formation chamber 42, and it is again returned to the unwinding chamber 38 and wound on the winding shaft 22 (wound into a roll). That is, the film formation apparatus 10 uses a roll-to-roll system.

In the present invention, the base film Z is not particularly limited, and any lengthy films (sheets) capable of film formation by vapor deposition method (vacuum film formation method), such as plasma-enhanced CVD, may be employed.

Specific examples of the base film Z that may be advantageously used include plastic (resin) films such as polyethylene terephthalate (PET), polyethylene naphthalate (PEN), polyethylene, polypropylene, polystyrene, polyamide, polyvinyl chloride, polycarbonate, polyacrylonitrile, polyimide, polyacrylate, polymethacrylate and polyvinyl fluoride (PVF).

A film obtained by forming layers (films) for realizing various functions such as planarizing layer, protective layer, adhesion layer, light-reflecting layer, antireflective layer and the like on a plastic film serving as a base may be used for the base film Z.

In the film formation apparatus 10, the vacuum chamber 12 of the opposing truck unit 50 is a cabinet with a rectangular shape of which one face is open, similar to vacuum chambers used in various vacuum film formation apparatuses (film formation apparatuses using vapor deposition).

Further, similar to an ordinary vacuum chamber, the vacuum chamber 12 is formed by a conductive metal material such as stainless steel.

The drum 14 is a cylindrical member which rotates counterclockwise about the central axis in FIG. 1.

The drum 14 winds the base film Z, which has been guided along a predetermined path by the guide roller 24 of the unwinding chamber 38, onto a predetermined region of its circumferential surface, and feeds it from the feeding chamber 40 to the film formation chamber 42, and then again feeds it from the feeding chamber 40 on an internal predetermined path, and again feeds it to the guide roller 26 of the unwinding chamber 38.

A film is formed in the film formation chamber 42 when the base film Z is being fed while supported on the drum 14.

Here, the drum 14 also acts as a counter-electrode to the shower head electrode 18 of the film formation chamber 42 described below (that is, the drum 14 and the shower head electrode 18 form an electrode pair).

Further, the drum 14 is connected to the bias power supply 32. The bias power supply 32 will be described later in detail.

The drum 14 may also have built-in temperature adjusting means for adjusting the temperature of the base film Z during film formation. The temperature adjusting means of the drum 14 is not particularly limited, and various types of temperature adjusting means may be used, such as temperature adjusting means in which a refrigerant is circulated, cooling means that uses a piezoelectric element, etc.

The shell 16 is a cylindrical cabinet which encompasses the drum 14.

A slit 16a for the base film Z to pass through when being guided from the guide roller 24 and wound around the drum 14, and a slit 16b for the base film Z which has undergone film formation to pass through while being fed from the drum 14 to the guide roller 26, are formed in the shell 16. In addition, an opening 16c for performing film formation on the base film Z, which also serves as a mask that restricts the film formation region on the base film Z, is formed in the part of the shell 16 opposing the shower head electrode 18.

Having this shell 16 is preferred because the opposing truck unit 50 and truck unit 52 can be easily positioned, and the drum 14 can be protected during maintenance of the apparatus, and, as described below, by having the partition walls 36a and 36b touch each other, an electrical contact can be formed between the opposing truck unit 50 and truck unit 52, and a potential difference between the two units does not readily occur.

In the illustrated embodiment, the shell 16 is formed of a conductive metal such as stainless steel.

As described above, the inside of the vacuum chamber 12 is separated in a substantially airtight manner from, as seen from the top of the diagram, the unwinding chamber 38, the feeding chamber 40 and the film formation chamber 42 by the two partition walls 36a and 36b.

The partition walls 36a and 36b are plate-like members affixed to the inner wall on the side in the side view (the side in the base film feeding direction) and on the deep side in the elevation view (deep side of FIG. 1A/left side of FIG. 1B), which separate the vacuum chamber 12 in the vertical direction in the diagram in a substantially air-tight manner. In the illustrated embodiment, the partition wall 36b is arranged below the partition wall 36a.

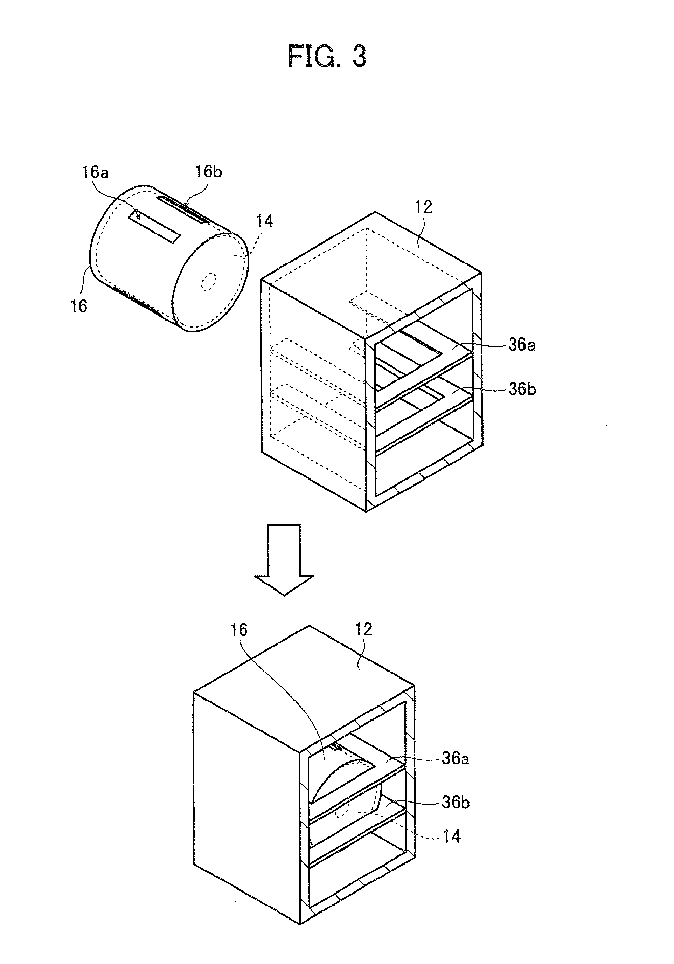

Further, in the partition walls 36a and 36b, there are rectangular notches described later, which open on the side of the truck unit 52, into which the shell 16 is inserted (refer to FIG. 3). That is, the partition walls 36a and 36b are substantially C-shaped members which open on the side of the truck unit 52.

In the illustrated film formation apparatus 10, the unwinding chamber 38 above the vacuum chamber 12 is formed by the inner wall 12a of the vacuum chamber 12, the upper circumferential surface of the shell 16 which encompasses the drum 14, and the partition wall 36a.

Further, the feeding chamber 40 in the center of the vacuum chamber 12 is formed by the inner wall 12a of the vacuum chamber 12, the center circumferential surface of the shell 16, the partition wall 36a and the partition wall 36b.

Additionally, the film formation chamber 42 below the vacuum chamber 12 is formed by the inner wall 12a of the vacuum chamber 12, the bottom circumferential surface of the shell 16 and the partition wall 36b.

In an ordinary apparatus, partition walls for separating the unwinding chamber or film formation chamber in a substantially airtight manner to increase the airtightness of each chamber are formed of insulating heat-resistant hard rubber, etc.

In contrast, in the film formation apparatus 10 of the present invention, the partition walls 36 are electrically conductive. This point will be described in detail below.

In the unwinding chamber 38, the supply shaft 20, the winding shaft 22, the guide rollers 24 and 26, and the supply shaft 20 are arranged.

The supply shaft 20 is a shaft which bears the base film roll 53 obtained by rolling the lengthy base film Z into a roll, such that it can rotate it. The guide rollers 24 and 26 are ordinary guide rollers which guide the base film Z on the predetermined feeding path. The winding shaft 22 is of a known type used for lengthy sheet-shaped materials, which winds the base film Z after film formation.

In the illustrated embodiment, the base film roll 53 is loaded on the supply shaft 20. Upon loading of the base film roll 53 on the supply shaft 20, the base film Z is passed along (inserted into) the predetermined path via the guide roller 24, the drum 14 and the guide roller 26, to reach the winding shaft 22.

In the film formation apparatus 10, the base film Z is fed from the base film roll 53 in synchronization with the winding of the base film Z, on which a film has been formed, on the winding shaft 22, and film formation is performed in the film formation chamber 42 on the surface of the base film Z that is wound around the drum 14 while the lengthy base film Z is fed on the predetermined feeding path in the longitudinal direction.

The feeding chamber 40 formed below the unwinding chamber 38 is the space through which the base film Z wound on the drum 14 passes before and after film formation.

The feeding chamber 40 has the effect of more reliably separating the winding chamber 38, where the base film roll 53 obtained by winding the base film Z before film formation is loaded and the base film Z on which film has been formed is wound, from the film formation chamber 42, where film formation on the base film Z is performed.

As described above, vacuum evacuation means 46 is connected to the unwinding chamber 38 and the feeding chamber 40.

The vacuum evacuation means 46 is for preventing the pressure of the unwinding chamber 38 or feeding chamber 40 from adversely affecting film formation in the film formation chamber 42, by reducing the pressure inside the unwinding chamber 38 or feeding chamber 40 to the pressure corresponding to the pressure of the film formation chamber 42 (film formation pressure).

In the present invention, the vacuum evacuation means 46 is not particularly limited, and exemplary means that may be used include vacuum pumps such as a turbo pump, a mechanical booster pump, a rotary pump and a dry pump, assist means such as a cryogenic coil, and various other known (vacuum) evacuation means which use means for adjusting the ultimate degree of vacuum or the amount of air discharged and are employed in vacuum film formation devices.

In this regard, the same holds true for the vacuum evacuation means 48 described below.

The film formation chamber 42 is formed below the feeding chamber 40.

In the illustrated film formation apparatus 10, the film formation chamber 42 is where film formation on the surface of the base film Z is performed by CCP (capacitively coupled plasma-enhanced)-CVD, for example. The shower head electrode 18 is arranged in the film formation chamber 42.

Further, raw material gas supply means 28 and an RF power supply 30 are connected to the shower head electrode 18. Additionally, the vacuum evacuation means 48 is connected to the film formation chamber 42.

Further, as described above, the bias power supply 32 is connected to the drum 14.

The shower head electrode 18 is of a known type used in CCP-CVD.

In the illustrated embodiment, the shower head electrode 18 is, for example, in the form of a hollow, substantially rectangular shape, and is arranged such that its largest surface faces the circumferential surface of the drum 14. The surface of the shower head electrode 18 that faces the drum 14 is curved in accordance with the circumferential surface of the drum 14, and a large number of through holes are formed on the entire surface.

In the illustrated embodiment, one shower head electrode 18 (film formation means using CCP-CVD) is provided in the film formation chamber 42. However, this is not the sole case of the present invention, and a plurality of shower head electrodes may be arranged in the direction of feeding of the base film Z. In this regard, the same holds true when plasma-enhanced CVD other than CCP-CVD is employed.

Further, the present invention is not limited to the case where the shower head electrode 18 is used; an ordinary plate-type electrode and a raw material gas supply nozzle may be used.

The raw material gas supply means 28 is of a known type used in vacuum film formation apparatuses such as plasma-enhanced CVD devices, and it supplies the raw material gas into the shower head electrode 18. As described above, a large number of through-holes are formed in the surface of the shower head electrode 18 facing the drum 14. Therefore, the raw material gases supplied into the shower head electrode 18 pass through the through-holes and are introduced into the space between the shower head electrode 18 and the drum 14.

The RF power supply 30 supplies plasma excitation power to the shower head electrode 18. The RF power supply 30 may be any of known RF power supplies used in various plasma-enhanced CVD devices.

In addition, the vacuum evacuation means 48 evacuates the film formation chamber 42 to keep it at a predetermined film formation pressure in order to form a film by plasma-enhanced CVD.

In the film formation apparatus 10 of the present invention, the film formed in the film formation chamber 42 is not particularly limited, and any film capable of film formation by plasma-enhanced CVD may be employed, including inorganic films such as silicon oxide, silicon oxynitride, aluminum oxide and silicon nitride, and transparent conductive films such as DLC (diamond-like carbon film) and ITO (indium tin oxide).

As described above, the bias power supply 32 is connected to the drum 14.

In the illustrated film formation apparatus 10, the drum 14 serves as the counter-electrode to the shower head electrode 18 (plasma excitation electrode) in film formation by CCP-CVD. In the film formation apparatus 10, by connecting the bias power supply 32 to the drum 14 and applying bias potential to the drum which is the counter-electrode, the film quality of the formed film, such as its density, can be improved, and productivity (film formation efficiency) can be improved, etc.

In the illustrated embodiment, the bias power supply 32 (power supply that supplies power to the drum 14) is, for example, an RF power supply, but the present invention is not limited thereto, and any power supply used for applying bias potential to a counter-electrode in CCP-CVD, such as an AC or DC pulse power supply, may be employed.

The film formation apparatus 10 of the present invention is not limited to applying bias potential to the drum 14; the drum 14 may be grounded, or the connection to the bias power supply 32 and ground may be switchable.

As described above, the film formation apparatus 10 is constructed by combining an opposing truck unit 50 and a truck unit 52.

The vacuum chamber 12 is arranged in the opposing truck unit 50, and the partition wall 36a and partition wall 36b (together called "partition walls 36" hereinafter) are affixed to the inner wall of the vacuum chamber 12. Further, the shower head electrode 18 connected to the RF power supply 30 is affixed on the bottom of the vacuum chamber 12.

On the other hand, in the truck unit 52, the drum 14, the supply shaft 20, the winding shaft 22 and the guide rollers 24 and 26, that is, the feeding system for the base film Z - is arranged. Further, the shell 16 which encompasses the drum 14 is also arranged in the truck unit 52.

The truck unit 52 has a plate-type base 54 on the bottom surface of which casters 52a are arranged, and a wall 56 affixed to the base 54 so as to stand up perpendicular to the base 54. The base 54 and wall 56 are both formed of a conductive metal such as stainless steel, similar to an ordinary film formation apparatus in which the truck and opposing truck are separate units.

The drum 14, the supply shaft 20, the winding shaft 22 and the guide rollers 24 and 26 are all supported on the wall 56 of the truck unit 52 by airtight bearings (not shown). Further, the shell 16 is also affixed to the wall 56.

Further, as shown in FIG. 1B, the wall 56 also serves as a cover that closes the open face of the vacuum chamber 12. To do so, an O ring 58 which closes the vacuum chamber 12 in an airtight manner, and which also contacts the edge of the open face of the vacuum chamber 12 (end of the wall of the vacuum chamber 12), is affixed around the edge of the wall 56.

Additionally, as shown in FIG. 1 and FIG. 2, the opposing truck unit 50 and truck unit 52 are both grounded.

As shown in FIG. 1 through FIG. 3, the film formation apparatus 10 is formed by combining the truck unit 52 and opposing truck unit 50 such that the shell 16 (drum 14) of the truck unit 52, the supply shaft 20 (base film roll 53), the guide rollers 24 and 26 and the winding shaft 22 are inserted inside the vacuum chamber 12. Further, as shown schematically in FIG. 3, the shell 16 is inserted into the notches of the partition walls 36a and 36b.

In the state where the truck unit 52 and the opposing truck unit 50 are combined, the shell 16 and the partition walls 36 are in contact in order to maintain the airtightness of each chamber. That is, the shell 16 is inserted into the notches of the partition walls 36 while sliding in contact with the partition walls 36.

Additionally, in the state after they have been combined, the edges of the partition walls 36 preferably contact the wall 56 in order to maintain the airtightness of each chamber.

As described above, the shell 16 is formed of a conductive metal such as stainless steel, and the partition walls 36 are conductive.

Therefore, in the state where the truck unit 52 and the opposing truck unit 50 have been combined, the two units are conductively joined (electrically connected) not only by the joined surface (contact part between the vacuum chamber 12 and wall 56), but also by the shell 16 and the partition walls 36.

By having such a configuration, the present invention prevents a potential difference from occurring between the truck unit 52 and the opposing truck unit 50, and further, it greatly reduces the distribution of potential difference within the apparatus, and inhibits generation of plasma in excess regions outside the film formation region arising from this potential difference.

As described above, because a plasma-enhanced CVD device that uses a roll-to-roll system requires various equipments, it has a large footprint, and a distribution tends to arise in ground potential. Moreover, since O ring seals for sealing are arranged at the joined parts between the opposing truck unit and the truck unit, they end up hindering the electrical connection of the joined parts. Additionally, depending on use, warping of the apparatus and deposition of film forming gases on the joined parts occurs as the film formation apparatus is used, because the opposing truck unit and the truck unit are repeatedly assembled and separated, and this also hinders the electrical connection of the joined parts between the two units.

For this reason, in a plasma-enhanced CVD device constructed of an opposing truck unit and a truck unit, a potential difference ends up occurring between the two units during film formation, and due to this potential difference, plasma is generated in unnecessary regions outside the film formation region (for example, in the unwinding chamber 38 in the case of the film formation apparatus 10), and as a result, damage to the base film, degradation of film quality, power loss, worsening of maintainability, etc., occur as described above.

In contrast, in the illustrated film formation apparatus 10, in the state where the truck unit 52 and the opposing truck unit 50 have been combined, the two units are conductively joined not only by the joined surface between the two units, by also by the shell 16 affixed to the truck unit 52 and the partition walls 36 affixed to the opposing truck unit 50.

For this reason, according to the film formation apparatus 10, a potential difference between the two units can be reliably prevented because sufficient electrical connection (conduction of electricity) is assured between the truck unit 52 and opposing truck unit 50. As a result, the film formation apparatus 10 sufficiently inhibits generation of plasma outside the film formation region, and greatly inhibits damage to the base film Z caused by generation of plasma in excess regions and the degradation of film quality that accompanies it, such that a properly formed high-quality functional film without damage to the base film Z can be stably manufactured.

In the illustrated film formation apparatus 10, the partition walls 36, used for conductively joining the truck unit 52 and opposing truck unit 50 in locations other than the joined surface between the two units, may be formed of a conductive metal such as stainless steel, but it is preferred that they have elasticity.

By providing the partition walls 36 (joining means that electrically join the truck unit 52 and opposing truck unit 50) with elasticity in this way, the partition walls 36 and shell 16 can be more reliably adhered, and the truck unit 52 and opposing truck unit 50 can be more reliably conductively joined.

An example of partition walls 36 having such elasticity is partition walls 36 obtained by covering the surface of a plate made of an elastic insulating material, such as heat-resistance hard rubber, for example, with a conductive film by plating, etc. Further, partition walls 36 obtained by covering the surface of a plate made of a similar elastic material with a conductive sheet-type material, such as aluminum foil, may be advantageously used.

Further, partition walls 36 constructed from conductive rubber, obtained by dispersing conductive microparticles of metal, carbon, etc. therein, are preferred.

Additionally, it is preferred that the partition walls 36 themselves are formed of a conductive metal such as stainless steel, and the partition walls are given elasticity by arranging elastic members such as springs, rubber or sponges on the affixed parts of the partition walls 36 on the inner wall of the vacuum chamber 12. The configuration wherein elastic members are provided on the affixed parts of the partition walls 36 may be used in combination with the aforementioned configurations.

In the film formation apparatus 10 of the present invention, various members may be used to conductively join the truck unit 52 and opposing truck unit 50, not limited to the shell 16 and partition walls 36.

For example, without using the shell 16, the truck unit 52 and opposing truck unit 50 can be conductively joined, other than by the joined surface of the two units, by putting the partition walls 36 in contact with the wall 56 of the truck unit 52, in the state where the partition walls 36 arranged on the opposing truck unit 50 are made conductive similar to the illustrated embodiment and the truck unit 52 and opposing truck unit 50 have been combined.

Further, in the state where a member for conductively joining the two has been provided on the truck unit 52 and/or opposing truck unit 50 and the truck unit 52 and opposing truck unit 50 have been combined, it is possible to conductively join the two units by these members. For example, in the state where a conductive member like an antistatic brush has been affixed to the inner wall of the vacuum chamber 12 and the truck unit 52 and opposing truck unit 50 have been combined, the truck unit 52 and opposing truck unit 50 can be conductively joined, other than by the joined surface of the two units, by putting this antistatic brush in contact with the guide roller 24.

The fact that elasticity is preferred is the same for these joining members other than the joined surface of the two units that conductively join the truck unit 52 and opposing truck unit 50.

However, since increasing the number of members unrelated to film formation in the vacuum chamber 12 is basically undesirable, it is preferred to use joining members that were originally in the film formation apparatus, such as the shell 16 and partition walls 36.

In particular, it is more preferable to use members that require being in tight contact, functionally speaking, such as the shell 16 and partition walls 36 of the illustrated embodiment, as the joining members.

The operation of the film formation apparatus 10 is described below.

In the ready state, the opposing truck unit 50 and the truck unit 52 are separated as shown in FIG. 2.

In this state, the base film roll 53 is loaded on the supply shaft 20 of the truck unit 52, and the base film Z is pulled out and passed into the predetermined feeding path, via the guide roller 24, the drum 14 and the guide roller 26, to reach the winding shaft 22.

Once the base film Z has been passed in, the truck unit 52 is moved so as to insert the feeding system for the base film Z, such as the drum 14, etc., inside the vacuum chamber 12 of the opposing truck unit 50, and the vacuum chamber 12 of the opposing truck unit 50 is closed by the wall 56 of the truck unit 52, and the opposing truck unit 50 and truck unit 52 are combined and affixed. Known methods may be used for affixing the two.

Once the opposing truck unit 50 and the truck unit 52 have been combined, the vacuum evacuation means 46 and 48 are started up, and evacuation of the unwinding chamber 38 and film formation chamber 42 begins.

Once the unwinding chamber 38, feeding chamber 40 and film formation chamber 42 have been evacuated to the predetermined degree of vacuum or below, the raw material gas supply means 28 is stared up, and raw material gas is supplied to the film formation chamber 42.

Once the pressure in the unwinding chamber 38, feeding chamber 40 and film formation chamber 42 has stabilized at the predetermined values, the rotation of the drum 14, etc., is started to begin feeding of the base film Z, and additionally, the RF power supply 30 and the bias power supply 32 are started up to begin film formation on the base film Z in the film formation chamber 42 while the base film Z is fed in the longitudinal direction.

Here, in the present invention, since the truck unit 52 and opposing truck unit 50 are conductively joined not only by the joined surface of the two units but also by the shell 16 and the partition walls 36, there is no potential difference between the two units, and therefore, generation of plasma in unnecessary regions, such as in the unwinding chamber 38, can be inhibited, there is no base film damage or film quality degradation, and proper film formation can be stably performed.

The base film Z on which a film has been formed is guided by the guide roller 26 and wound around the winding shaft 22.

The film formation apparatus 10 shown in FIG. 1 is an apparatus that forms a film on the base film Z by CCP-CVD, but the present invention is not limited thereto, and other types of plasma-enhanced CVD, such as ICP-CVD method, may also be advantageously used.

Further, the film formation performed in the film formation apparatus of the present invention is not limited to plasma-enhanced CVD, and may be used in any film formation apparatus that requires supply of power for film formation, such as film formation methods accompanied by the generation of plasma, like sputtering, etc.

Further, the film formation apparatus of the present invention is not limited to a film formation apparatus that performs film formation in the state where the base film Z is wound around a drum as in the illustrated embodiment, and it can also be used in CCP-CVD, etc., which performs film formation while feeding the base film in a straight line between a pair of plate-like electrodes arranged in parallel, for example.

However, in a film formation apparatus that performs film formation in the state where the base film Z is wound around a drum as in the illustrated embodiment, a potential difference readily occurs in the apparatus because voltage is also applied outside the film formation region. For this reason, a film formation apparatus that performs film formation in the state where the base film Z is wound around a drum as in the illustrated embodiment can be advantageously used from the viewpoint that the effects of the present invention can be manifested more advantageously.

While the film formation apparatus of the present invention has been described above in detail, the present invention is by no means limited to the foregoing embodiment, and it should be understood that various improvements and modifications are possible without departing from the scope and spirit of the present invention.

### Working Examples

Next, the present invention is described in further detail by referring to specific working examples of the present invention.

### [Working Example 1]

The film formation apparatus 10 shown in FIG. 1 was used to form a silicon oxide film on a base film Z.

Both the partition wall 36a and partition wall 36b were those made by covering the entire surface of a partition wall made of hard rubber (nitrile rubber) with aluminum foil.

The base film Z used was a polyester resin film (polyethylene terephthalate film made by Fujifilm) having a width of 300 mm.

The raw material gases of the silicon oxide film produced by CCP-CVD were HMDSO (hexamethyldisiloxane), oxygen gas and nitrogen gas, and the film formation pressure was 80 Pa.

The RF power supply 30 used was an RF power supply of frequency 13.56 MHz, and the plasma excitation power supplied to the shower head electrode 18 was 2000 W.

Further, the bias power supply 32 used was an RF power supply of frequency 400 kHz, and the bias power supplied to the drum 14 was 500 W.

Under such film formation conditions, a silicon oxide film was formed in the film formation apparatus 10 on the base film Z having a length of 20 m. The base film feeding speed was 2 m/minute.

During film formation, the inside of the vacuum chamber 12 was observed through an observation window provided in the vacuum chamber 12. As a result, no generation of plasma in unnecessary regions outside the film formation region (between the drum 14 and the shower head electrode 18) was seen.

Further, when the base film Z after film formation was finished was observed by optical microscope, no damage caused by plasma was seen on the base film Z.

Additionally, when the inside of the vacuum chamber 12 was visually checked after film formation was finished, no deposition of film was seen in the unwinding chamber 38 or feeding chamber 40.

### [Working Example 2]

Film formation of a silicon oxide film on a base film Z was performed in exactly the same way as in working example 1, except that the partition walls 36 were changed to a conductive rubber substance obtained by dispersing carbon in nitrile rubber.

Similar to working example 1, generation of plasma during film formation, the state of the base film and deposition of film inside the vacuum chamber were checked. As a result, similar to working example 1, no generation of plasma, damage to the base film or deposition of film was seen.

### [Working Example 3]

Film formation of a silicon oxide film on a base film Z was performed in exactly the same way as in working example 1, except that elastic members (sponges made of nitrile rubber) were provided on the affixed parts of the partition walls 36 in the vacuum chamber 12.

Similar to working example 1, generation of plasma during film formation, the state of the base film and deposition of film inside the vacuum chamber were checked. As a result, similar to working example 1, no generation of plasma, damage to the base film or deposition of film was seen.

### [Working Example 4]

Film formation of a silicon oxide film on a base film Z was performed in exactly the same way as in working example 1, except that the partition walls 36 were made of stainless steel, and springs were inserted in their affixed parts.

Similar to working example 1, generation of plasma during film formation, the state of the base film and deposition of film inside the vacuum chamber were checked. As a result, similar to working example 1, no generation of plasma, damage to the base film or deposition of film was seen.

### [Comparison Example]

Film formation of a silicon oxide film on a base film Z was performed in exactly the same way as in working example 1, except that the partition walls were not covered with aluminum foil.

Similar to working example 1, generation of plasma during film formation, the state of the base film and deposition of film inside the vacuum chamber were checked. As a result, generation of plasma was seen in the unwinding chamber 38 and the feeding chamber 40 during film formation. Further, damage thought to be due to plasma was seen on the base film after film formation. Additionally, deposition of film was seen in the unwinding chamber 38 and the feeding chamber 40 in the vacuum chamber 12 after film formation.

The results as described above demonstrate the merits of the present invention.

According to the present invention, a functional film can be stably manufactured without heat damage to the base film or delamination or cracking of the film caused by this heat damage, and therefore to the present invention can be advantageously used in the manufacture of gas barrier films, etc.

## Claims

1. A film formation apparatus which performs film formation while feeding a lengthy base film in the longitudinal direction, the film formation apparatus comprising:
a first unit having a vacuum chamber in which film formation is performed on the base film;
a second unit having a feeding system for feeding the base film; and
joining means that conductively joins the first unit and second unit,
wherein the first unit and the second unit are constructed by combining together, and no potential difference occurs between the first unit and second unit during film formation.

2. The film formation apparatus according to claim 1, wherein the second unit has a cylindrical drum, and film formation is performed on the base film while the base film is fed in the longitudinal direction while being wound on the circumferential surface of the drum.

3. The film formation apparatus according to claim 2, wherein the joining means includes partition walls that separate a film formation region from regions other than the film formation region in the vacuum chamber.

4. The film formation apparatus according to claim 3, wherein the second unit has a frame that surrounds the drum, and the joining means includes the frame.

5. The film formation apparatus according to claim 4, wherein the partition walls are provided in the first unit, and when the first unit and the second unit have been combined, the frame and the partition walls touch each other.

6. The film formation apparatus according to any one of claims 1 to 5, wherein the joining means has elasticity.

7. The film formation apparatus according to any one of claims 1 to 6, wherein the first unit has an electrode for plasma generation incorporated in the vacuum chamber.

8. The film formation apparatus according to claim 7, wherein the second unit has a cylindrical drum for feeding the base film wound on the circumferential surface of the drum, and an electrode pair is constructed by the drum and the electrode for plasma generation

9. The film formation apparatus according to any one of claims 1 to 8, wherein at least one of the first unit and the second unit has wheels for movement.

10. The film formation apparatus according to any one of claims 1 to 9, wherein the base film is fed from a base film roll obtained by winding the lengthy base film into a roll, and the base film on which film formation has been completed is wound into a roll.
